# EUROPEAN PATENT APPLICATION

(11) **EP 0 851 507 A2**
(43) Date of publication of application: **01.07.1998**
(21) Application number: 97302440.9
(22) Date of filing: 09.04.1997
(51) Int. Cl.: H01L 29/78, H01L 21/336

(54) **Method for fabricating a DMOS transistor**

(30) Priority: 28.12.1996 KR 9674323
(71) Applicant: Samsung Electronics Co., Ltd., Suwon City, Kyungki-do (KR)
(72) Inventor: Cha, Seung-Joon, Sucho-4 dong, Sucho-ku, Seoul (KR)
(74) Representative: Style, Kelda Camilla Karen

(57) **Abstract**

Disclosed is an improved method for fabricating double-diffused MOS (DMOS) transistors, comprising the steps of thermally oxidizing a previously formed oxide layer on a semiconductor substrate to form a partially and relatively thick oxide layer before performing a POCl₃ doping. During the POCl₃ doping to render a conductivity to a gate polysilicon layer, phosphorus of the POCl₃ can not be penetrated into the substrate through the relatively thick oxide layer. A completed DMOS device has the channel region in the P type body and in the source/drain region which has an ununiform provision of impurity concentration, and results in increase of a withstanding voltage.

## Description

The present invention relates generally to an improved method for fabricating double-diffused MOS (DMOS) transistors and, more particularly, to an improved method of fabricating DMOS power transistors that can be used either in a discrete or an integrated structure.

Future intelligent power ICs will require high-density power devices along with analog functions and VLSI logic. DMOS transistors are important in power device applications capable of handling high voltages. For such devices, one figure of merit is the current handling capacity per unit area or the ON resistance per unit area. For a given voltage rating, the ON resistance per unit area may be reduced by reducing the cell area of the MOS device.

In the field of power transistors, the combined width of the polycrystalline silicon (polysilicon) and the contact region, which forms the gate and source electrode, respectively, is defined as the cell pitch of the device. For a DMOS power transistor, a known technique to reduce the width of the polysilicon region is to decrease the P-well junction depth. However, minimum junction depth is defined by the breakdown voltage required.

A conventional structure Lateral DMOS (LDMOS) device is well suited for incorporation into VLSI processes because of its simplicity. However, LDMOS devices have been considered inferior to Vertical DMOS (VDMOS) devices, and therefore have not received significant attention. Recently, a RESURF (Reduced SURface Field) LDMOS device with good specific on-resistance (Rₛₚ) has been demonstrated. But that device structure is more complex and not very versatile, being limited to grounded source applications.

More specifically, in the past, DMOS transistors have been utilized either as discrete power transistors or as components in monolithic integrated circuits. DMOS transistors are inherently conservative of semiconductor substrate area because of the manner in which they are fabricated in a self-aligned fabrication sequence.

A channel body region is usually first formed by dopant introduction of one type dopant (P or N impurities) through an aperture in a mask of gate-forming material to provide a channel region which is self-aligned with the gate. Then a source region is usually formed by dopant introduction of a type opposite to that of the channel body region through the existing aperture so that the source is self-aligned to both the gate electrode and the channel body region. This permits a very compact structure.

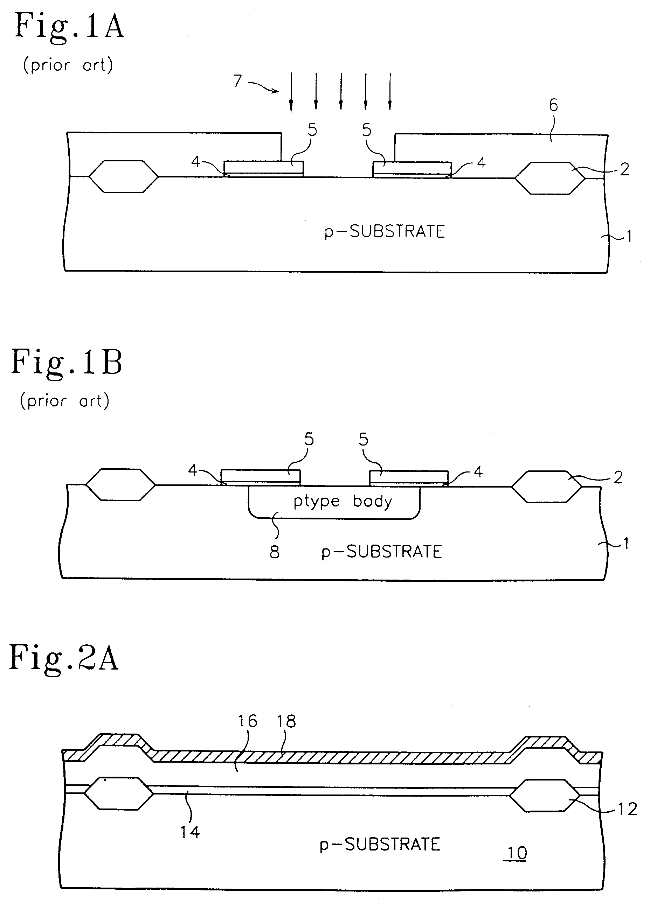

Referring to Figs. 1A and 1B, a conventional method for fabricating a typical DMOS transistor is described hereinafter.

First, as shown in Fig. 1A, a field oxide layer 2 is formed on a P- type semiconductor substrate 1 according to a well-known LOCOS (local oxidation of silicon) process in the art. Then a layer 4 of oxide (silicon dioxide) is preferably thermally grown or deposited over the surface of the substrate 1 including over the substrate surface. This oxide layer 4 will preferably and subsequently serve as the gate insulator of the completed DMOS device. Next a layer of, for example, 5000 Angstroms of polycrystalline silicon is deposited on the insulating layer 4 and patterned, preferably by a conventional photolithographic masking and etching techniques, leaving one or more conductive gate electrode regions 5 with each gate electrode region 5 serving as the gate electrode for a completed DMOS device. Also on the substrate structure, a photoresist layer is deposited and patterned to form a body forming mask 6. A P type region (a P type body) 8 is formed in the surface of the P- type substrate 1 by, for example, conventional photolithographic masking, etching and diffusion techniques using a P type dopant source 7 such as boron.

Particularly, so as to render a conductivity to the gate electrode regions 5, a POCl₃ doping or a ion implantation has been used before performing a heat treatment at high temperature. If desired, ion implantation techniques can be used to form the P type body 8 and the number of the P type body would depend on whether a discrete DMOS device was being formed or whether one or more DMOS devices were being used in an integrated circuit configuration. The P type body 8 doped with P type semiconductor material will be eventually used as the high conductivity or low resistivity contact regions for the body channel of the completed DMOS device.

However, in fabrication of such a DMOS device using POCl₃ doping and a heat treatment, particularly for power devices, there arise two problems. One of the two problems is that the channel region in the P type body 8 has an ununiform provision of impurity concentration. This is because P type impurity injected into the gate electrode region 18 is diffused in the undesired directions during the formation of the P type body 8 and an n⁺ type drain/source region. The impurity concentration of, particularly, the drain region is relatively lowered to that of other regions. More particularly, a partially region of the P type body which is nearly adjacent to the drain region has a rather lower concentration of the impurities. As a result, if an increased drain voltage is applied to the completed DMOS device, the drain region which is nearly adjacent to the channel region leads easily to depletion, and thereby a punchthrough occurs therein. So, electrical characteristics of the completed DMOS device, particularly, a withstanding voltage, is seriously lowered.

In order to prevent the above described withstanding voltage from being lowered, it is necessary to increase a channel length between the P type body and the source region. This, however, arises an undesirable problem that a DMOS chip size is increased.

The other of the two problems is that it is difficult to make the gate polysilicon have conductivity by diffusing an N type conductive source such as, POCl₃, Wsiₓ or the like. This is because the P type body 8 is previously formed by doping with P type impurities before diffusion of the conductive source in the gate polysilicon. If the conductive gate is formed by using a diffusion of POCl₃, an additional masking layer must be inevitably used for formation of the conductive gate.

Also when the conductive gate is formed without the use of such an additional masking layer, an impurity ion implantation in place of the diffusion of POCl₃ must be inevitably used. In case of such an ion implantation, the required resistance of the conductive gate is undesirably increased. When a diffusion of Wsiₓ is used, this arises a new problem of lifting with respect to layers.

In order to solve the above described problems, if an ion implantation for forming P type body is performed before forming a gate electrode region, this arises a problem of misalignment during the formation of the P type body. With the high integration of semiconductor devices, particularly of DMOS devices, each gate length is shortened. Thus the above misalignment exerts a serious influence on device characteristics.

Additionally, it is necessary to form a very low-resistance, electrical short channel between the channel body region and the source region to prevent undesired parasitic transistor action that may occur without shorting the body region to the source region. Because the channel body region is lightly doped, and a low resistance electrical contact to a semiconductor region typically requires a heavily-doped surface region, it is necessary to provide an auxiliary heavily doped contact region for the channel body region to insure a good electrical contact to both the source and body regions. Such a heavily doped body region usually can not be self-aligned and hence there is an increase in the overall size of the DMOS device. Typically, the heavily doped body contact region is usually formed before the other two regions. Then a rather thick masking oxide patterned layer is used to protect the heavily doped body contact region against the source region dopant introduction step. The necessity to etch away or remove this masking oxide patterned layer together with any oxide over the source regions without disturbing the insulator over and/or under the gate electrode increased costs, tolerances, and process complexity and, as a result, decreased the yields of electrically good devices.

While various processes having been utilized in an attempt to ameliorate the foregoing problem, a need existed to provide an improved DMOS fabrication method and process sequence which allows an effective source to channel body electrical short without decreasing yield and which permits or is susceptible to device dimensional reduction.

It is therefore an aim of certain embodiments of the present invention to provide an improved process for the fabrication of a DMOS transistor having excellent device characteristics.

It is another aim of certain embodiments of the present invention to provide an improved fabrication method for a DMOS transistor which results in a lower resistance of its gate and a higher yield of good devices.

It is still another aim of certain embodiments of the present invention to provide an improved fabrication method or process sequence of a DMOS transistor whose source and drain regions are simultaneously formed and at the same time whose gate polysilicon has a conductivity.

It is still a further aim of certain embodiments of the present invention to provide an improved process for fabricating DMOS transistors in integrated circuits.

According to an aspect of the present invention, a method for fabricating a DMOS transistor device comprises the steps of preparing a semiconductor substrate; forming a first insulating layer on the semiconductor substrate; sequentially forming a gate polysilicon layer and a second insulating layer on the first insulating layer; patterning the gate polysilicon layer as well as the second insulating layer to form source and drain windows on the semiconductor layer; forming a body of a first conductivity type in the substrate through the source window by an ion-injection using a body forming mask; thermally oxidizing an exposed portion of the first insulator layer to form a relatively thick oxide layer; and forming source and drain regions of a second conductivity type in the substrate through the source and drain windows. The method further comprises a step of forming a spacer on both side walls of the gate polysilicon layer. Also, the method further comprises a step of, after patterning the gate polysilicon layer, performing POCl₃ doping so as to render a conductivity to the gate polysilicon layer. The method further comprises a step of removing the relatively thick oxide layer to have a predetermined thickness enough to inject an impurity through the oxide layer.

According to another aspect of the present invention, a method for fabricating a DMOS transistor device comprises the steps of preparing a P- type semiconductor substrate; forming a first insulating layer on the semiconductor substrate; sequentially forming a gate polysilicon layer and a second insulating layer on the first insulating; patterning the gate polysilicon layer as well as the second insulating layer to open source and drain windows; injecting P type impurities into the substrate through the source window to form a P type body; thermally oxidizing an exposed portion of the first insulating layer to form a relatively thick oxide layer; and injecting N+ type impurities into the substrate through the source and drain windows to form heavily doped N+ type source and drain regions.

This invention may be understood and its objects will become apparent to those skilled in the art by reference to the accompanying drawings as follows;
Figs. 1A and 1B are flow diagrams illustrating by sequential cross-sectional representation the process steps of a conventional method for fabricating a DMOS transistor; and
Figs. 2A through 2H are flow diagrams illustrating by sequential cross-sectional representation the process steps of a novel method for fabricating a DMOS transistor embodying the present invention.

The making and use of the presently preferred embodiment are disclosed below in detail. However, it should be appreciated that the present invention provides many applicable inventive concepts which can be embodied in a wide variety of specific context. The specific embodiment discussed is merely illustrative of specific ways to make and use the invention, and do not limit the scope of the invention.

The following is a description of a fabrication method embodying the present invention. The preferred method of fabricating a DMOS transistor will be described hereinafter.

Referring first to Fig. 2A, a P type semiconductor substrate 10 is provided with an isolation region 12 of silicon oxide film provided thereon. The isolation region 12 is provided to electrically separate DMOS elements from each other. Generally, the isolation region 12 of a silicon oxide film, which is a highly dielectric material, is formed by a well-known isolation type process such as LOCOS (Local Oxidation of Silicon) process.

In this example, the substrate 10 comprises a p-type, about 10 to 20Ω-cm substrate. Also, the substrate configuration is not critical to the present invention and may be provided with a semiconductor layer (not shown) or an epitaxially deposited layer (not shown) provided thereon. Each of these layers has the same conductivity as the substrate 10, but a relatively lower concentration to the substrate 10. In this case, either the semiconductor layer or the epitaxially deposited layer can be electrically isolated by the isolation region 12. For more detailed example, an epitaxial layer or N type material is deposited on a P type substrate to form a semiconductor layer (not shown) on the substrate and then the isolation region 12 of silicon oxide is formed by the isolation type process, so that portions of the semiconductor layer are electrically isolated by the isolation region 12.

Referring again to Fig. 2A, a layer 14 of oxide (silicon dioxide) is preferably thermally grown or deposited over the surface of the substrate 10. This oxide layer 14 will preferably serve as the gate insulator of the completed DMOS transistor. Subsequently, on the insulating layer 14, a layer 16 of, for example, about 5000 Angstroms of polycrystalline silicon (hereinafter, referred to as "polysilicon") is deposited. Then an insulating layer 18 of, for example, about 2000 Angstroms of silicon nitride is formed on the polysilicon layer 16.

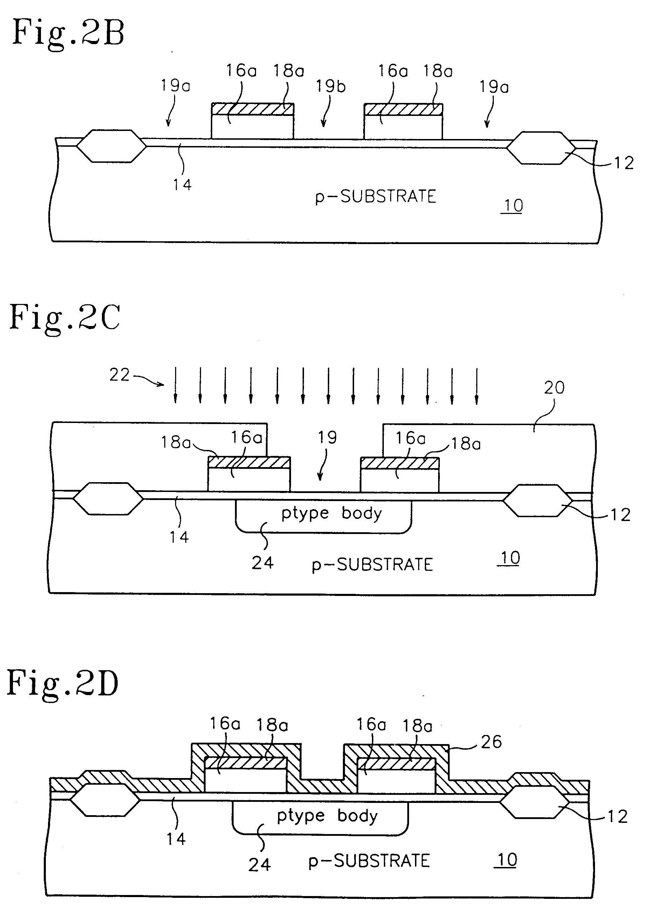

Referring next to Fig. 2B, the insulating layer 18 is patterned, preferably by a well-known photolithographic masking and etching techniques, leaving one or more portions 18a of the insulating layer 18. The polysilicon layer 16 is then patterned by a well-known etching technique using the insulator portions 18a as a mask. So, drain and source windows 19a and 19b are defined.

Proceeding now to Fig. 2C, a photoresist layer is deposited on the substrate structure and patterned by the photolithographic masking and developing techniques, leaving one or more portions 20 of the photoresist layer to open the source window 19b only. Namely, the photoresist portions 20 serving as a masking layer are formed over drain windows 19a. In this example, the masking layer can be any photolithography masking layer. Next, a P type doping is introduced through the source window 19b formed by the masking layer 20. A suitable P type dopant 22, such as boron, is most conveniently and accurately introduced by ion implantation through the insulating layer 14. The doping which is previously introduced are then driven into the substrate 10 by a heat treatment at high temperature in order to form a lightly doped P type body 24. Because of lateral diffusion during the drive in diffusion operation, it should be noted that the lightly doped P type body 24 extends outwardly (under the centra of the gate oxide layer 14 that is under the undoped gate polysilicon layer 18a) thereby providing optimum channel region for the N channel DMOS device that is formed by the process of the invention.

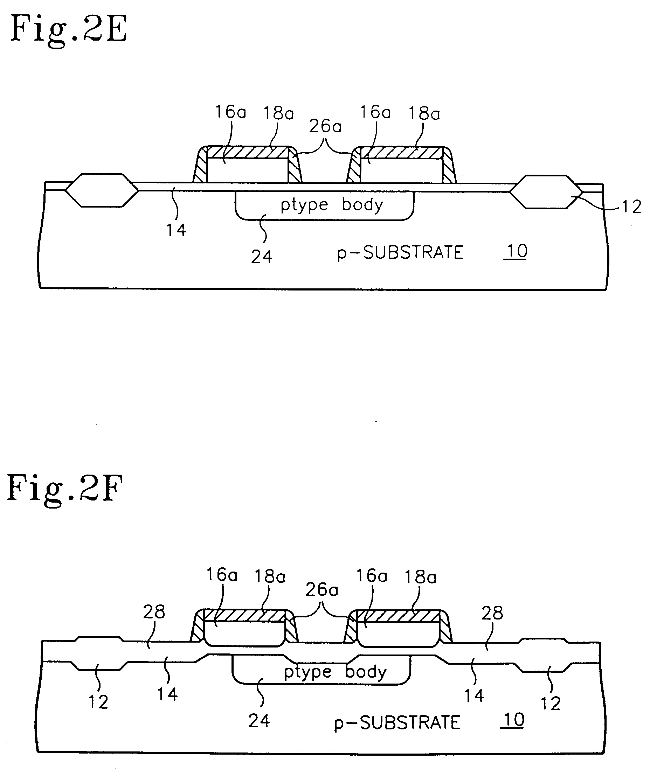

Referring now to Figs. 2D and 2E, after the masking layer 20 is removed, a thin insulating layer 26, preferably a nitride such as a Si₃N₄ layer is formed over all portions of the surface of the semiconductor substrate and partially removed by a well-known dry etching process in this art, so that sidewall insulating regions (or, spacers) 26a are then formed on each of the combined sidewalls of the gate polysilicon layer and the insulating layer 18a. The sidewall regions 26a are typically an oxide and may be performed using a TEOS (tetraethoxysilane) process. Alternatively, the side wall regions may comprise a nitride region. The insulating layer 18a serves as a mask during formation of the sidewall regions 26a. Also the insulating layer 14 serves as an etching stopper during the formation of the sidewall regions 26a.

As illustrated in Fig. 2F, an oxidizing operation is carried out or introduced during this drive-in diffusion step to grow an oxide layer 28 on the exposed portions of the gate oxide layer 14 and the field oxide layer 12. The combined region of the insulating layer 18a and the sidewall regions 26a serves as a mask during the oxide growth. The insulating layer 12 is formed rather thicker at the exposed portions of the gate oxide layer 14 which correspond to drain and source regions of the completed DMOS device. The thick portion formed thus is provided to enhance the withstanding voltage of the completed DMOS device.

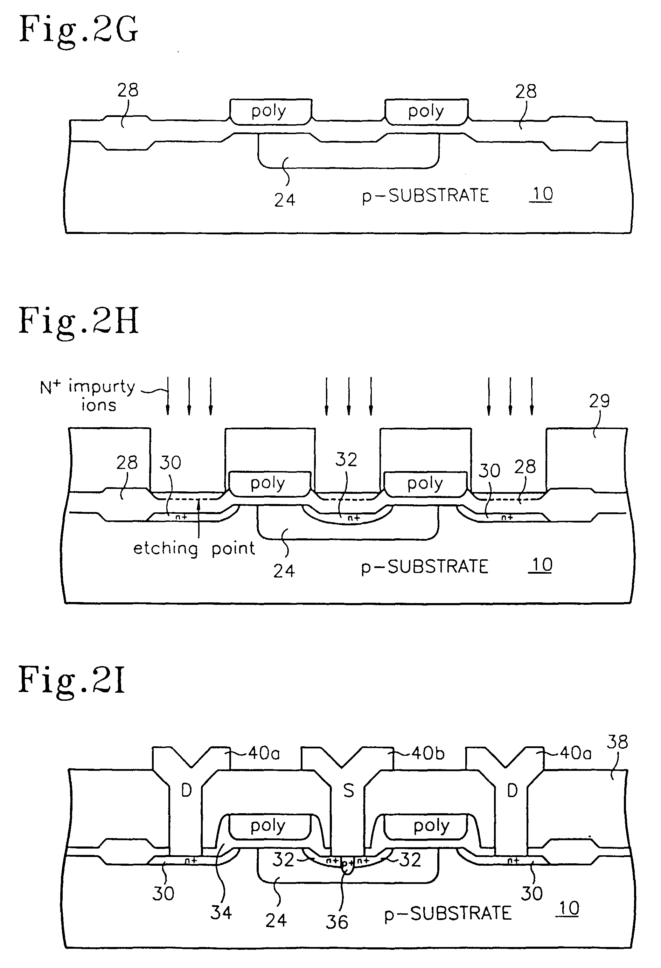

Referring now to Fig. 2G, after the insulating layer 18a and the sidewall regions 26a are removed, a POCl₃ solution is covered over all portions of the surface of the semiconductor substrate and then a diffusion drive-in heat treatment is carried out. During the course of this diffusion drive-in heat treatment, the phosphorus in the POCl₃ film or layer (not shown) is transferred or conveyed directly into the gate polysilicon layer 16a so that the gate polysilicon layer 16a has a conductivity. However, the phosphorus is not penetrated into the substrate through the thick oxide layer 28.

Next, as shown in Fig. 2H, a layer of, for example, a photoresist layer or a nitride layer is deposited and patterned by the photolithography to form a masking layer 29 having a source/drain window and thereby to define a source/drain region. And by a well-known etching process, the oxide layer 28 continues to be partially removed until an etching point (shown by a broken line of Fig. 2H) is exposed. Subsequently, n⁺ type ion implantation is performed using the masking layer 20 as a mask to form the heavily doped N+ drain region 30 and the heavily doped N+ source region 32.

Following process steps thereafter are carried out in the identical manner with the process steps of a typical CMOS device to fabricate the completed DMOS device.

As shown in Fig. 2I, an insulating layer is formed over all portions of the surface of the semiconductor layer and selectively removed by the dry etching process. Then sidewall region 34 is formed on both sidewalls of the gate polysilicon 16a. These sidewall regions 34 typically comprise an oxide such as silicon dioxide, or a nitride such as a Si₃N₄ layer. During formation of the sidewall regions 34, the combined oxide layer on the drain and the source regions 30 and 32 becomes rather thinner. Next, the oxide layer on the source region 32 is partially removed to form a contact window. A diffusion process is then performed to form a heavily doped P+ body contact region 36 through the source region 32.

Finally, a metallization process is used to form the conductive layers 40a and 40b to complete the structure illustrated in Fig. 2H. An insulating layer 38, such as silicon dioxide, is deposited over the device and conductive contacts and interconnect lines are formed to electrically couple the DMOS device to other devices on the intergrated circuit.

As described above, according to a novel method for fabricating DMOS transistor, a uniform provision of impurity concentration in the channel region of the P type body and in the source/drain region can be obtained so that a device characteristic, particularly a withstanding voltage, of the DMOS transistor can be improved.

Also, the method can prevent depletion at part of the P type body, which is nearly adjacent to the drain region, from being generated. Therefore, even though an increased drain voltage is applied to the completed DMOS device, the drain region which is nearly adjacent to the channel region does not lead to depletion, and thereby a punchthrough can be improved.

## Claims

1. A method for fabricating a DMOS transistor device comprising the steps of:
preparing a semiconductor substrate;
forming a first insulating layer on the semiconductor substrate;
sequentially forming a gate polysilicon layer and a second insulating layer on the first insulating layer;
patterning the gate polysilicon layer as well as the second insulating layer to form source and drain windows on the semiconductor layer;
forming a body of a first conductivity type in the substrate through the source window by an ion-injection using a body forming mask;
thermally oxidizing an exposed portion of the first insulator layer to form a relatively thick oxide layer; and
forming source and drain regions of a second conductivity type in the substrate through the source and drain windows.

2. The method of claim 1, further comprising a step of forming a spacer on both side walls of the gate polysilicon layer.

3. The method of claim 1 or 2, further comprising a step of, after patterning the gate polysilicon layer, performing POC1₃ doping so as to render a conductivity to the gate polysilicon layer.

4. The method of claim 3, wherein the step of performing the POCl₃ doping comprises the steps of covering a POCl₃ film on an entire surface of the semiconductor substrate, and performing a heat treatment to diffuse phosphorus in the POCl₃ film directly into the gate polysilicon layer.

5. The method of any of the preceding claims, further comprising a step of removing the relatively thick oxide layer to have a predetermined thickness enough to inject an impurity through the oxide layer.

6. The method of any one of the preceding claims, wherein the step of forming the source and the drain regions comprises forming sidewall regions on both side walls of the gate polysilicon layer; thermally oxidizing exposed portions of the first insulating layer to form a relatively thick oxide layer on the source and the drain regions; and diffusing impurity ions into the substrate through the relatively thick oxide layer to form the source and the drain regions.

7. The method of claim 6, wherein the impurity ions comprises an N type dopant.

8. The method of claim 7, wherein the N type dopant comprises phosphorus of POC1₃.

9. The method of claim 7, wherein the N type dopant comprises a Wsiₓ.

10. The method of any one of the preceding claims, wherein the first insulating layer comprises a thermally growing silicon dioxide.

11. The method of any one of the preceding claims, wherein the step of forming the gate polysilicon layer comprises forming a second insulating layer on the polysilicon layer, patterning the second insulating layer to form a gate forming mask, and patterning the polysilicon layer using the gate forming mask to form a gate polysilicon.

12. The method of any one of the preceding claims, wherein the body forming mask is formed by forming a pattern of photoresist.

13. The method of any one of the preceding claims, wherein the step of forming a pattern of photoresist comprises depositing a photoresist layer over the substrate and patterning the photoresist layer to define a body window portion.

14. The method of any one of the preceding claims, further comprising the step of forming an element isolation region prior to forming the first insulating layer.

15. The method of claim 14, wherein the element isolation region comprises a dielectric layer.

16. The method of claim 15, wherein the dielectric layer comprises a silicon oxide film.

17. The method of claim 14, 15 or 16 wherein the element isolation region is formed by LOCOS process.

18. A method for fabricating a DMOS transistor device comprising the steps of:
preparing a P- type semiconductor substrate;
forming a first insulating layer on the semiconductor substrate;
sequentially forming a gate polysilicon layer and a second insulating layer on the first insulating;
patterning the gate polysilicon layer as well as the second insulating layer to open source and drain windows;
injecting P type impurities into the substrate through the source window to form a P type body;
thermally oxidizing an exposed portion of the first insulating layer to form a relatively thick oxide layer; and
injecting N+ type impurities into the substrate through the source and drain windows to form heavily doped N+ type source and drain regions.
